# EUROPEAN PATENT APPLICATION

(11) **EP 4 596 106 A1**
(43) Date of publication of application: **06.08.2025**
(21) Application number: 24154880.9
(22) Date of filing: 31.01.2024
(51) Int. Cl.: B01L 3/00, B81C 1/00, B81C 3/00

(54) **INTEGRATED FLUIDIC-ELECTRICAL BONDING**

(71) Applicant: Imec VZW, 3001 Leuven (BE)
(72) Inventor: LABIE, Riet, 3210 Lubbeek (BE); ARNETT, Chad, 1090 Jette (BE); SANGAM, Srikanth, 3000 Leuven (BE)
(74) Representative: Winger

(57) **Abstract**

The present invention relates to a method for integrating a first substrate with a second substrate by establishing an electrical connection between them. The method includes providing a first substrate with an accessible first electrical contact and a bonding layer that is in physical contact with the first substrate's surface. The bonding layer features a patterned fluidic pathway and an access hole that exposes the first electrical contact. The access hole is filled with a conductive material to create an electrical connection to the first electrical contact. Subsequently, the bonding layer is bonded to a second substrate that has a second electrical contact exposed on its surface, such that the conductive material also establishes an electrical connection with the second electrical contact. This integration method facilitates the creation of complex structures with both electrical and fluidic interconnectivity between substrates.

## Description

### Field of the Invention

The present invention relates to the field of microfluidic device fabrication and integration, specifically to methods for simultaneous fluidic and electrical bonding of microfluidic chips.

### Background of the Invention

The field of microfluidics has seen significant advancements in recent years, particularly in the integration of silicon (Si) microfluidic sensor chips into larger, macro-scaled devices. These devices are becoming increasingly important in a variety of applications, including medical diagnostics, environmental monitoring, and biochemical assays. The integration of these microfluidic chips into devices typically requires the establishment of both electrical and fluidic connections to interface with the external environment.

A persistent challenge in the field is the need to create these connections in a reliable and efficient manner. Traditionally, the processes for establishing fluidic and electrical connections are carried out separately. Fluidic connections are made to allow for the flow of liquids or gases through the microfluidic channels, while electrical connections are necessary for the operation of the sensors and the transmission of data to and from the chip. This separation of processes can lead to increased complexity in manufacturing, larger form factors for the devices, and potentially longer electrical paths that can affect the performance and sensitivity of the sensors.

The current state of the art typically involves wire bonding and the use of an interposer printed circuit board (PCB) to establish these connections. Wire bonding, while widely used, requires multiple steps including die attachment, wirebonding, and often the application of a protective coating. This not only adds to the complexity of the assembly process but also necessitates additional space to accommodate the wire bonds and protective materials. Moreover, the separation of fluidic and electrical connections can lead to inefficiencies in the manufacturing process and may limit the potential for miniaturization of the devices.

Despite the progress made in the field, there remains a need for further advancements to address the challenges associated with the integration of microfluidic sensor chips into macro-scaled devices. Specifically, there is a need for a more streamlined process that can simultaneously establish both fluidic and electrical connections in a manner that is conducive to miniaturization, efficiency, and potentially enhanced performance of the integrated system.

### Summary of the Invention

It is an object of embodiments of the present invention to enable simultaneous fluidic and electrical bonding of substrates. This objective is accomplished by a method according to the invention.

In the first aspect, the present invention relates to a method for integrating a first substrate with a second substrate, the method comprising providing a first substrate having a first electrical contact accessible from a surface of the first substrate; providing a bonding layer in physical contact with said surface of the first substrate, the bonding layer having a first main surface and a second main surface, a patterned fluidic pathway, and an access hole crossing the bonding layer and opening to the first main surface and the second main surface, wherein providing the bonding layer is performed in such a way that the access hole exposes the first electrical contact; filling the access holes with a conductive material to establish an electrical connection with the first electrical contact; bonding the bonding layer with a second substrate having a second electrical contact exposed on a surface thereof, the bonding being performed in such a way that the conductive material establishes an electrical connection with the second electrical contact.

In embodiments, the bonding layer may be patterned with the fluidic pathway and access hole before being applied to the first substrate.

In embodiments, the bonding layer may further comprise a release liner on its first main surface, the release liner having the same pattern as the bonding layer. This embodiment provides the advantage of protecting the adhesive surface until it is ready to be used, ensuring cleanliness and preventing premature adhesion. Furthermore, the pattern in the release liner gives different additional advantages whether it is removed before or after filling the access hole. If it is removed before, a smaller Height/Width aspect ratio can be obtained, while if it is removed after, a larger aspect ratio is obtained and the release liner acts as mask, avoiding contamination of the bonding layer surface by conductive material particles or other particles produced during the filing process.

Hence, in embodiments, the method may further comprise a step of removing the release liner after filling the access hole with the conductive material and before bonding, and in other embodiments, the method may further comprise a step of removing the release liner before filling the access hole with the conductive material and before bonding.

In embodiments, the bonding layer may comprise at least one pressure-sensitive adhesive layer. This embodiment provides the advantage of enabling bonding at low pressures and temperatures, which can be beneficial for delicate substrates.

In embodiments, the bonding layer may be provided by a lamination step. This embodiment provides the advantage of a uniform and controlled application of the bonding layer, which can improve the quality of the bond. For applications where patterning is performed before the bonding layer is provided on the first substrate, providing the bonding layer may comprise lamination, with patterning accomplished for instance through methods such as laser cutting, blade cutting, or punching.

In embodiments, the bonding layer may be a transfer adhesive or a double-sided pressure-sensitive adhesive with a non-adhesive core and a release layer covering one adhesive layer. This embodiment provides the advantage of allowing for easy handling and application of the bonding layer.

In embodiments, the bonding layer may be applied to the first substrate and then patterned. This embodiment provides the advantage of customizing the pattern of the bonding layer to match specific design requirements.

In embodiments, the bonding layer may be applied by spin coating. This embodiment provides the advantage of achieving a thin and uniform layer, which is advantageous for maintaining precise dimensions of the fluidic pathways and electrical contacts. For applications where patterning is performed after the bonding layer is provided on the first substrate, providing the bonding layer may comprise spin coating, blade coating, lamination, printing, or dispensing. Patterning in these cases may be carried out using lithography or laser patterning. In the case of printing and dispensing, patterning can be simultaneous with the provision of the bonding layer because printing or dispensing can serve the dual function of both deposition and patterning of the bonding layer. Hence, in embodiments, the bonding layer may be applied to the first substrate and patterned at the same time.

In embodiments, filling the access hole with the conductive material may be performed by screen-printing or dispensing. This embodiment provides the advantage of precise control over the amount and placement of the conductive material.

In embodiments, the width of the access hole may range from 1 to 500 µm, preferably from 20 to 400 µm, more preferably from 50 to 150 µm. This embodiment provides the advantage of maintaining the structural integrity of the bonding layer.

In embodiments, providing the bonding layer may comprise a step of forming the fluidic pathway and the access hole simultaneously in the same step. This embodiment provides the advantage of reducing the number of manufacturing steps, thereby increasing efficiency.

In embodiments, **forming** the fluidic pathway and the access hole may be performed by laser patterning, blade patterning, lithography, printing, or dispensing (patterned deposition). This embodiment provides the advantage of high precision in creating the desired patterns for fluidic and electrical integration.

In embodiments, the width of the access hole may range from 1 to 100 µm and they may be formed by lithography. This embodiment provides the advantage of achieving very fine features suitable for high-density electrical connections.

In embodiments, the width of the access hole may range from 50 to 500 µm and they may be formed by laser patterning. This embodiment provides the advantage of a versatile method for creating larger features when needed.

In embodiments, the width of the access hole may be above 500 µm. This embodiment provides the advantage of creating large openings for applications requiring robust electrical connections.

In embodiments, lithography may be used to enable a width of the access hole or of the fluidic pathway below 100 µm. This embodiment provides the advantage of fine feature resolution, e.g., for miniaturized devices.

In embodiments, the width of the fluidic pathway may be below 100 µm, e.g., from 1 to 100 µm. This embodiment provides the advantage of creating narrow channels suitable for microfluidic applications.

In embodiments, the aspect ratio height/width of the access hole may be from 0.5 to 2.0. In embodiments, the aspect ratio height/width of the fluidic pathway may be from 0.5 to 2.0. This embodiment provides the advantage of optimizing the flow characteristics and mechanical stability of the fluidic pathways.

In embodiments, the fluidic pathway may be crossing the bonding layer and opening to the first main surface and the second main surface. This embodiment provides the advantage of enabling through-layer fluidic connections, which can simplify the design of multi-layered devices and can connect fluidic channels present in both substrates.

In embodiments, the first substrate may have a first fluidic channel and/or the second substrate may have a second fluidic channel, wherein providing the bonding layer is performed in such a way that the fluidic pathway establishes a fluidic connection with the first fluidic channel, and wherein bonding the bonding layer with the second substrate is performed in such a way that the fluidic pathway establishes a fluidic connection with the second fluidic channel. This embodiment provides the advantage of ensuring proper alignment and connectivity between the fluidic channels of the two substrates.

In embodiments, the thickness of the bonding layer may be from 5 to 200 µm, preferably 10 to 100 µm, more preferably from 20 to 60 µm. This embodiment provides the advantage of a bonding layer thickness that is suitable for a wide range of applications, balancing flexibility and structural support.

In embodiments, the height of the access hole and the fluidic pathway may be the same and is equal to the thickness of the bonding layer. This embodiment provides the advantage of simplifying the manufacturing process by using the same dimension for both the access holes and the fluidic pathways.

In embodiments, the second electrical contact on the second substrate may be coplanar with said surface or projects vertically with a height of less than 1 µm, preferably less than 500 nm, more preferably less than 400 nm, even more preferably less than 300 nm, yet more preferably 200 nm or less. Most preferably, it is coplanar with said surface. These embodiments provide the advantage of ensuring a low-profile electrical connection that does not interfere with the bonding process or the overall device thickness.

In embodiments, the fluidic pathway may comprise lateral channels. This embodiment provides the advantage of creating complex fluidic networks within a single bonding layer.

In embodiments, the bonding layer may comprise at least two fluidic pathways separated by no more than 500 µm or wherein the fluidic pathway is a branched pathway. This embodiment provides the advantage of enabling multiple fluidic connections in close proximity, which can be useful for parallel processing or analysis in microfluidic devices.

In embodiments, the bonding may be performed at room temperature. This embodiment provides the advantage of avoiding thermal stress on the substrates, which can be particularly beneficial for temperature-sensitive materials or components.

In the second aspect, the present invention relates to a structure, e.g., a semiconductor structure, comprising a first substrate with a first electrical contact accessible from a surface of the first substrate; a bonding layer in physical contact with said surface of the first substrate, the bonding layer having a first main surface and a second main surface, a patterned fluidic pathway, and an access hole crossing the bonding layer and opening to the first main surface and the second main surface, wherein the access hole exposes the first electrical contact; a conductive material filling the access hole to establish an electrical connection with the first electrical contact; and a second substrate bonded to the bonding layer, the second substrate having a second electrical contact exposed on a surface thereof, wherein the conductive material establishes an electrical connection with the second electrical contact.

Any element of the second aspect can be as correspondingly described in any embodiment of the first aspect.

It is an advantage of embodiments of the present invention that a more compact and efficient integration can be realized. It is a further advantage of embodiments of the present invention that the electrical path between components can be significantly shortened, which may lead to improved signal integrity and faster response times. Additionally, it is an advantage of embodiments of the present invention that the processes for establishing fluidic and electrical connections can be carried out simultaneously, thereby simplifying the manufacturing process and reducing production time and costs. It is yet another advantage of embodiments of the present invention that the need for an interposer printed circuit board (PCB) may be eliminated, which can further reduce the overall size and complexity of the device.

Moreover, it is an advantage of embodiments of the present invention that the use of a polymer adhesive layer not only defines fluidic channels but also facilitates the bonding of substrates, thereby serving a dual purpose and contributing to the miniaturization of the device. It is an additional advantage of embodiments of the present invention that the conductive paste can be applied in a manner that is less labor-intensive compared to traditional wire bonding methods, which typically involve multiple steps and additional materials such as protective top coating. It is also an advantage of embodiments of the present invention that the adhesive layer can be patterned with access holes that, when filled with conductive paste, form direct electrical connections, thereby streamlining the assembly process.

Furthermore, it is an advantage of embodiments of the present invention that the bonding layer can be patterned with both the fluidic pathway and access holes in a single step, which can lead to a more efficient manufacturing process. It is an advantage of embodiments of the present invention that the bonding process can be performed at room temperature, which may be beneficial for the stability and integrity of temperature-sensitive components.

Lastly, it is an advantage of embodiments of the present invention that the resulting structure is capable of providing robust fluidic and electrical connections, which is very advantageous for the reliable operation of integrated microfluidic and electronic systems. This can lead to a wide range of applications, including but not limited to, the integration of silicon sensors with microfluidic devices in various fields such as biomedical research, environmental monitoring, and chemical analysis.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 is a flowchart of the method for integrating a first substrate with a second substrate according to embodiments of the present invention.
Fig. 2 is a series of step-by-step illustrations of the method for integrating a first substrate with a second substrate without using a release liner according to embodiments of the present invention.
Fig. 3 is a series of step-by-step illustrations of the method for integrating a first substrate with a second substrate using a release liner according to embodiments of the present invention.

In the different figures, the same reference signs refer to the same or analogous elements.

### Detailed description of Illustrative Embodiments

The present invention will be described with respect to particular embodiments and with reference to certain drawings, but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top and over and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", also used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be interpreted as being limited to devices consisting only of components A and B. It means that with respect to the present invention, the only relevant components of the device are A and B. The term "comprising" therefore covers the situation where only the stated features are present and the situation where these features and one or more other features are present. The word "comprising" according to the invention therefore also includes as one embodiment that no further components are present. When the word "comprising" is used to describe an embodiment in this application, it is to be understood that an alternative version of the same embodiment, wherein the term "comprising" is replaced by "consisting of", is also encompassed within the scope of the present invention.

Similarly, it is to be noticed that the term "coupled" should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some, but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

As used herein, and unless otherwise specified, the term "first substrate (100)" refers to the initial base material or layer upon which subsequent layers or structures are built or added. The first substrate may for instance comprise a semiconductor material (e.g., Si), glass, or a polymer. This can include, but is not limited to, semiconductor wafers (e.g., Si wafers), printed circuit boards, glass plates, or any other suitable material that serves as a foundational element in the construction of electronic, optical, fluidic or mechanical devices.

As used herein, and unless otherwise specified, the term "second substrate (200)" refers to an additional base material or layer that is attached to the first substrate (100) as part of a construction or assembly process. The second substrate may for instance comprise a semiconductor material (e.g., Si), glass, or a polymer. This can include materials similar to those used for the first substrate, such as semiconductor wafers (e.g., Si wafer), printed circuit boards, glass plates, or other materials that are compatible with the intended application of the final assembly. A typical example is a polymer fan-out cartridge.

As used herein, and unless otherwise specified, when an electrical contact is said to be accessible from a surface of a substrate, it can be on the substrate, in the substrate and coplanar therewith or at the bottom of a depression in the substrate.

As used herein, and unless otherwise specified, the term "bonding layer (300)" refers to an intermediate layer or material that is used to adhere, connect, or bond the first substrate (100) to the second substrate (200). This layer may have adhesive properties and can be composed of various materials such as polymers (e.g., adhesives) or any other material that can facilitate the bonding of two substrates. The bonding layer may be a single layer or a composite of multiple layers with different properties.

As used herein, and unless otherwise specified, the term "patterned fluidic pathway (330)" refers to a specifically designed and structured channel or groove within the bonding layer (300) that is intended to direct or manage the flow of fluids. This pathway can be created using various patterning techniques such as etching, laser cutting, or lithography and can be designed to connect fluidic channels or ports in the substrates being bonded.

As used herein, and unless otherwise specified, the term "access hole (340)" refers to an aperture or opening that traverses the bonding layer (300) from one main surface to the other. This hole is designed to allow for the passage of materials, such as conductive material (350), to create an electrical connection between elements on the first substrate (100) and the second substrate (200). The access hole can be created using techniques such as drilling, punching, or laser cutting. The Access hole and the fluidic pathway can both be made by either the same technique or different techniques. Preferably, they are made by the same technique. More preferably, they are made simultaneously by the same technique.

As used herein, and unless otherwise specified, the term "conductive material (350)" refers to any substance or composition that is capable of conducting electricity and is used to fill the access hole (340) to establish an electrical connection between the first electrical contact (110) and the second electrical contact (210). Examples of conductive materials include, but are not limited to, conductive epoxies, solders, conductive inks, or metal alloys.

As used herein, and unless otherwise specified, the term "release liner (360)" refers to a protective layer or film that is applied to the bonding layer (300) to prevent premature adhesion or contamination. This liner is typically removed prior to or after certain processing steps, such as filling the access hole (340) with conductive material (350) or bonding the substrates together. The release liner may be made of materials such as silicone-coated paper or plastic films.

As used herein, and unless otherwise specified, the term "pressure-sensitive adhesive layer" refers to a type of adhesive that forms a bond when pressure is applied to marry the adhesive with the adherend. No solvent, water, or heat is needed to activate the adhesive, which is typically tacky at room temperature.

As used herein, and unless otherwise specified, the term "non-adhesive core" refers to a central layer or component within a multi-layered bonding layer (300) that does not possess adhesive properties. This core can provide structural support, act as a barrier, or serve other functions within the bonding layer while being flanked by adhesive materials.

As used herein, and unless otherwise specified, the term "fluidic channel" refers to a channel or conduit designed to carry fluids within the first substrate (100) or the second substrate (200). These channels can be used for various purposes, including but not limited to, transporting liquids or gases, mixing fluids, or controlling fluid flow in microfluidic applications.

As used herein, and unless otherwise specified, the term "lateral channels" refers to channels that extends parallel to the surfaces of the bonding layer. They can be part of a single channel opening on both surfaces or they can be secondary channels that branch off from a main fluidic pathway (330) within the bonding layer (300). These channels can be used to distribute fluids to different locations or to create multiple fluidic connections within a device.

As used herein, and unless otherwise specified, the term "branched pathway (520)" refers to a fluidic pathway (330) within the bonding layer (300) that divides into two or more subsidiary pathways. This branching can be used to split fluid flow, create parallel processing paths, or distribute fluids to multiple destinations within a device.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

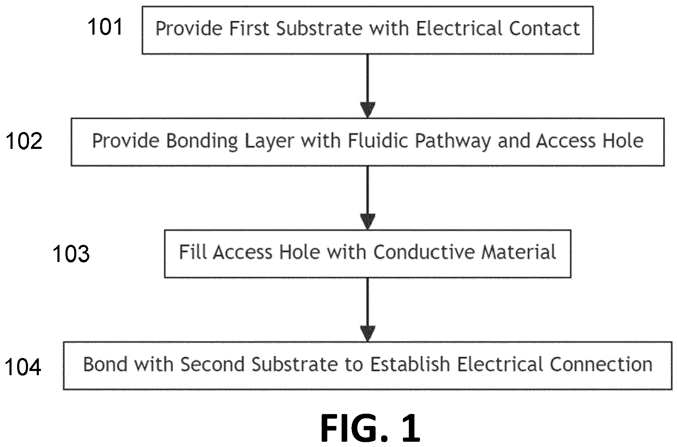

Figures 1, 2, and 3 illustrate the various steps and configurations of the method and structure. Fig. 1 is a flowchart outlining the method for integrating the first substrate (100) with the second substrate (200), showing the provision (101) of the first substrate (100) with the first electrical contact (110), the provision (102) of the bonding layer (300) with its patterned fluidic pathway (330) and access hole (340), the filling (103) of the access holes (340) with conductive material (350), and the bonding (104) with the second substrate (200) with the second electrical contact (210).

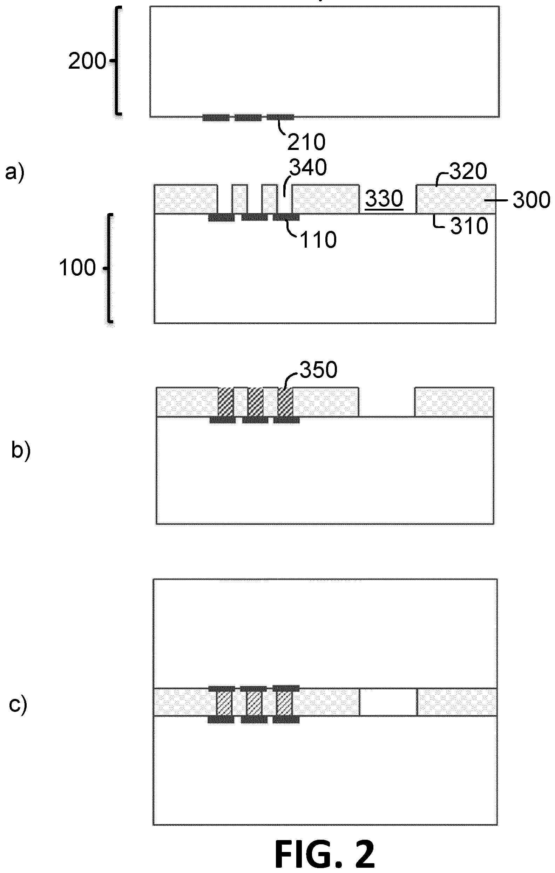

Fig. 2 illustrates the method without the use of a release liner, showing the application of the bonding layer (300) to the first substrate (100), the filling of the access hole (340) with conductive material (350), and the bonding to the second substrate (200) with the second electrical contact (210).

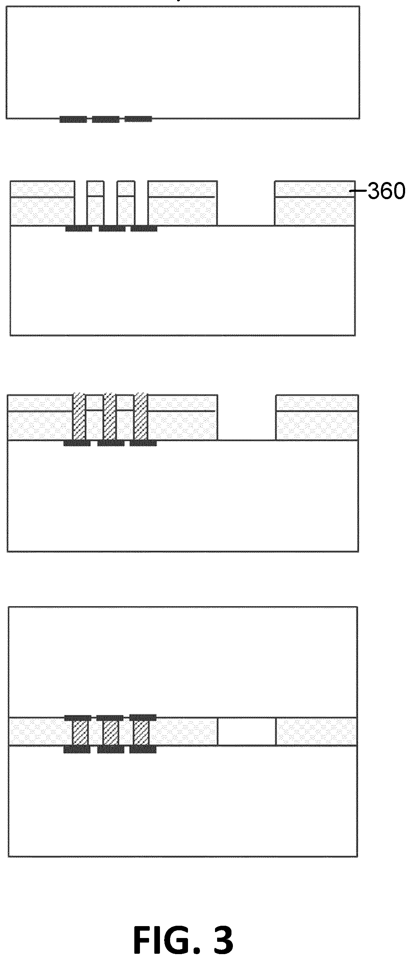

Fig. 3 depicts the method using a release liner (360), where the release liner (360) is removed either before or after filling the access hole (340) with conductive material (350), followed by bonding to the first substrate (100) and then to the second substrate (200) with the second electrical contact (210).

The described method and structure provide a coherent and integrated approach to substrate integration, ensuring electrical and fluidic connectivity with precision and reliability.

We now refer to Figs. 2 and 3.

The present invention relates to a method for integrating a first substrate (100) with a second substrate (200), and to a structure comprising such substrates. The method includes several steps and aspects that are designed to ensure a seamless and robust integration of the substrates both electrically and fluidically.

We now refer to Fig. 2a. In a first aspect, the method comprises providing a first substrate (100) having a first electrical contact (110) accessible from a surface of the first substrate (100). A bonding layer (300) is then provided in physical contact with said surface of the first substrate (100). The bonding layer (300) has a first main surface (310) and a second main surface (320), a patterned fluidic pathway (330), and an access hole (340) crossing the bonding layer (300) and opening to the first main surface (310) and the second main surface (320). The access hole (340) is aligned such that it exposes the first electrical contact (110). We now refer to Fig. 2b. The access holes (340) are filled with a conductive material (350) to establish an electrical connection with the first electrical contact (110). We now refer to Fig. 2c. Finally, the bonding layer (300) is bonded with a second substrate (200) having a second electrical contact (210) exposed on a surface thereof, ensuring that the conductive material (350) establishes an electrical connection with the second electrical contact (210).

The bonding layer (300) may be patterned with the fluidic pathway (330) and access hole (340) before being applied to the first substrate (100). We now refer to Fig. 3. In some embodiments, a release liner (360) on the first main surface (310) of the bonding layer (300), mirroring the pattern of the bonding layer (300), protects the adhesive surface until it is ready to be used. The release liner (360) is removed before or after filling the access hole (340) with the conductive material (350) and before bonding.

The bonding layer (300) may comprise at least one pressure-sensitive adhesive layer, enabling bonding at low pressures and temperatures, which is beneficial for delicate substrates. It may be provided by a lamination step for uniform application, or it may be a transfer adhesive or a double-sided pressure-sensitive adhesive with a non-adhesive core and a release liner covering one adhesive layer for easy handling. Alternatively, the bonding layer (300) may be applied by spin coating to achieve a thin and uniform layer.

Filling the access hole (340) with the conductive material (350) may be performed by screen-printing or dispensing for precise control. The width of the access hole (340) may range from 1 to 500 µm to accommodate various sizes of electrical contacts. The fluidic pathway (330) and the access hole (340) may be formed simultaneously by laser patterning, lithography, or blade cutting for high precision and reduced manufacturing steps.

The first substrate (100) may have a first fluidic channel (400), and the second substrate (200) may have a second fluidic channel (500), with the fluidic pathway (330) establishing fluidic connections between them. The thickness of the bonding layer (300) may be from 5 to 200 µm, and the height of the access hole (340) and the fluidic pathway (330) may be the same and equal to the thickness of the bonding layer (300). The second electrical contact (210) on the second substrate (200) may be coplanar with its surface or project vertically with a height of less than 1 µm.

In a further embodiment, the bonding layer comprises a polymer adhesive layer. This is advantageous as it serves to define the access hole and the fluidic pathway, optionally connect the fluidic channels, and simultaneously bond the substrates, streamlining the manufacturing process. The access hole (340) patterned in the adhesive layer to be filled with conductive material, facilitates direct electrical connections. This conductive material application is performed prior to final bonding of both substrates, which reduces the number of steps compared to traditional wirebonding and glop top application, as the conductive material can be applied directly into the access holes (340), creating a more efficient assembly process.

Moreover, the top substrate may include an electrical pattern, adding electrode features onto a fluidic cartridge, which can be particularly useful for applications requiring integrated sensing or actuation within the fluidic system. This integration allows for a smaller form factor and shorter electrical path compared to wire bonding, which can be advantageous in compact device designs.

The invention's method also potentially omits the need for an interposer printed circuit board (PCB), further simplifying the assembly and reducing the overall thickness of the final product. This is particularly beneficial in applications where space is at a premium or where the thickness of the device is critical.

Embodiments of this invention enable, for instance, the integration of silicon sensors with electrical connections to microfluidic devices. This application highlights the potential for this technology to play a significant role in the development of advanced biomedical devices and diagnostic tools.

In a second aspect, the present invention relates to a structure, e.g., semiconductor structure comprising a first substrate (100) with a first electrical contact (110) accessible from a surface of the first substrate (100); a bonding layer (300) in physical contact with said surface of the first substrate (100), the bonding layer (300) having a first main surface (310) and a second main surface (320), a patterned fluidic pathway (330), and an access hole (340) crossing the bonding layer (300) and opening to the first main surface (310) and the second main surface (320), wherein the access hole (340) exposes the first electrical contact (110); a conductive material (350) filling the access hole (340) to establish an electrical connection with the first electrical contact (110); and a second substrate (200) bonded to the bonding layer (300), the second substrate (200) having a second electrical contact (210) exposed on a surface thereof, wherein the conductive material (350) establishes an electrical connection with the second electrical contact (210).
Any element of the second aspect may be as correspondingly described in the first aspect.

### Example: Optimization of Conductive Paste Application for Simultaneous Bonding

This example aims to optimize the application of conductive paste for simultaneous fluidic and electrical bonding, focusing on the integration of a silicon sensor chip with a fan-out cartridge. The goal is to refine the process to ensure reliable electrical connections through the adhesive layer while maintaining the integrity of the fluidic channels.

Materials required include a silicon sensor chip, a fan-out cartridge with an electrical pattern, conductive paste, and a pressure-sensitive adhesive layer with a release liner. Equipment needed comprises a laminator, screen-printing or dispensing tools, and potentially a laser patterner or lithography setup for access hole and fluidic pathway formation.

The procedure involves the following steps:
1. Apply the polymer adhesive layer to the silicon sensor chip.
2. Pattern the adhesive layer with fluidic pathways and access holes using the chosen method (lithography, laser patterning, or blade cutting) based on the desired dimensions.
3. Fill the access holes with conductive paste using screen-printing or dispensing techniques, ensuring complete filling without overflow.
4. If a release liner is present, remove it before or, preferably, after the conductive paste application.
5. Bond the adhesive layer with the fan-out cartridge (which is in fact the second substrate (200)), aligning the conductive paste-filled access holes with the electrical contacts on the cartridge.

The optimized application of conductive paste results in robust electrical connections between the silicon sensor chip and the fan-out cartridge. The fluidic channels remain intact and functional, with no leakage or obstruction. The process demonstrates improved reliability and repeatability, suitable for scaling to production levels.

It is to be understood that although preferred embodiments, specific constructions and configurations, as well as materials, have been discussed herein for devices according to the present invention, various changes or modifications in form and detail may be made without departing from the scope of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method for integrating a first substrate (100) with a second substrate (200), the method comprising:
• providing a first substrate (100) having a first electrical contact (110) accessible from a surface of the first substrate (100);
• providing a bonding layer (300) in physical contact with said surface of the first substrate (100), the bonding layer (300) having: o a first main surface (310) and a second main surface (320), o a patterned fluidic pathway (330), and o an access hole (340) crossing the bonding layer (300) and opening to the first main surface (310) and the second main surface (320), wherein providing the bonding layer (300) is performed in such a way that the access hole (340) exposes the first electrical contact (110);
• filling the access holes (340) with a conductive material (350) to establish an electrical connection with the first electrical contact (110);
• bonding the bonding layer (300) with a second substrate (200) having a second electrical contact (210) exposed on a surface thereof, the bonding being performed in such a way that the conductive material (350) establishes an electrical connection with the second electrical contact (210).

2. The method of claim 1, wherein the bonding layer (300) is provided by a lamination step.

3. The method of claim 1 or 2, wherein the bonding layer (300) is patterned with the fluidic pathway (330) and access hole (340) before being applied to the first substrate (100).

4. The method of claim 3, further comprising a release liner (360) on the first main surface (310) of the bonding layer (300), the release liner (360) having the same pattern as the bonding layer (300).

5. The method of claim 4, further comprising a step of removing the release liner (360) after filling the access hole (340) with the conductive material (350) and before bonding.

6. The method of any one of the preceding claims, wherein the bonding layer (300) comprises at least one pressure-sensitive adhesive layer (370), and preferably the bonding layer (300) is a double-sided pressure-sensitive adhesive with a non-adhesive core (380) and a release layer covering one adhesive layer (370).

7. The method of claim 1, wherein the bonding layer (300) is applied to the first substrate (100) and then patterned.

8. The method of claim 7, wherein the bonding layer (300) is applied by spin coating, blade coating, lamination, printing, or dispensing.

9. The method of any one of the preceding claims, wherein providing the bonding layer (300) comprises a step of forming the fluidic pathway (330) and the access hole (340) simultaneously in the same step.

10. The method of any one of the preceding claims, wherein forming the fluidic pathway (330) and the access hole (340) is performed by laser patterning, blade cutting, punching, or lithography.

11. The method of claim 1, wherein the first substrate (100) has a first fluidic channel and/or the second substrate (200) has a second fluidic channel, wherein providing the bonding layer (300) is performed in such a way that the fluidic pathway (330) establishes a fluidic connection with the first fluidic channel, and wherein bonding the bonding layer (300) with the second substrate (200) is performed in such a way that the fluidic pathway (330) establishes a fluidic connection with the second fluidic channel.

12. The method of any one of the preceding claims, wherein the second electrical contact (210) on the second substrate (200) is coplanar with said surface or projects vertically with a height of less than 500 nm, preferably less than 400 nm, more preferably less than 300 nm, yet more preferably 200 nm or less.

13. The method of any one of the preceding claims, wherein the fluidic pathway (330) comprises lateral channels.

14. The method of any one of the preceding claims, wherein the bonding is performed at room temperature.

15. A structure comprising:
• a first substrate (100) with a first electrical contact (110) accessible from a surface of the first substrate (100);
• a bonding layer (300) in physical contact with said surface of the first substrate (100), the bonding layer (300) having:
∘ a first main surface (310) and a second main surface (320),
∘ a patterned fluidic pathway (330), and
∘ an access hole (340) crossing the bonding layer (300) and opening to the first main surface (310) and the second main surface (320),
wherein the access hole (340) exposes the first electrical contact (110);
• a conductive material (350) filling the access hole (340) to establish an electrical connection with the first electrical contact (110); and
• a second substrate (200) bonded to the bonding layer (300), the second substrate (200) having a second electrical contact (210) exposed on a surface thereof, wherein the conductive material (350) establishes an electrical connection with the second electrical contact (210).
